# EUROPEAN PATENT APPLICATION

(11) **EP 2 631 936 A1**
(43) Date of publication of application: **28.08.2013**
(21) Application number: 12156687.1
(22) Date of filing: 23.02.2012
(51) Int. Cl.: H01L 21/677, B65G 13/02, C23C 14/56

(54) **Plate conveying system for manufacturing of photovoltaic modules**

(71) Applicant: Pramac Swiss S.A., 6595 Riazzino (CH)
(72) Inventor: Pellegrino, Fabio, 6616 LOSONE (Ticino) (CH)
(74) Representative: Deambrogi, Edgardo

(57) **Abstract**

A support (30) for conveying a substrate panel (14) in a reaction chamber (10) for the deposition of a thin film is described, comprising a roller (32) for moving the panel (14) relative to a hot plate assembly (12), the roller being translatable longitudinally between a first operating position at a distance from the hot plate assembly (12) and a second operating position close to the hot plate assembly (12), and being at least partially exposed by a coaxial protective element (36) which is axially slidable on a support member (38) fixed to a structure of the reaction chamber. The protective element (36) is coupled to the support member (38) by means of a pair of longitudinal supporting elements (50) positioned symmetrically about an axial vertical plane of the element.

## Description

The present invention generally relates to electronic circuit production technology, and in particular to installations for producing photovoltaic modules.

In particular, the invention relates to systems for conveying substrate panels on to a hot plate in a reaction chamber for the deposition of thin films, and more specifically the invention relates to a support for a conveying system of the type defined in the preamble of Claim 1.

An installation for producing photovoltaic modules comprises a sequence of workstations, which are typically used for the collection and cleaning of the substrates (glass sheets) between which the laminated structure composed of a plurality of photovoltaic cells in series and/or in parallel is to be formed, for the deposition of the layers of active semiconductor material and related electrodes is performed, and finally for the packaging of the finished product. The laminated panel forming the solar cells of a photovoltaic module is generally laid down in a sequence of planar deposition steps, namely the deposition of a transparent electrode layer directly on to the front glass substrate, the deposition of the semiconductor layer (or layers), the deposition of a second electrode layer, and a reflection barrier if necessary, followed by the application of the rear glass sheet.

The transparent electrode layer is formed by deposition of a thin film of transparent conductive oxide (TCO), typically zinc (doped if necessary) on the front glass panel, by a chemical vapour deposition method in a reaction chamber in which the glass panel forming the deposition substrate is placed in contact on a hot plate, and is exposed to a flow of gaseous precursors of zinc oxide from above. The layer of zinc oxide is grown on the panel by controlling the process temperature (the temperature at the surface of the plate is about 150°C), the process pressure (typically in vacuum conditions) and the gas flow rate.

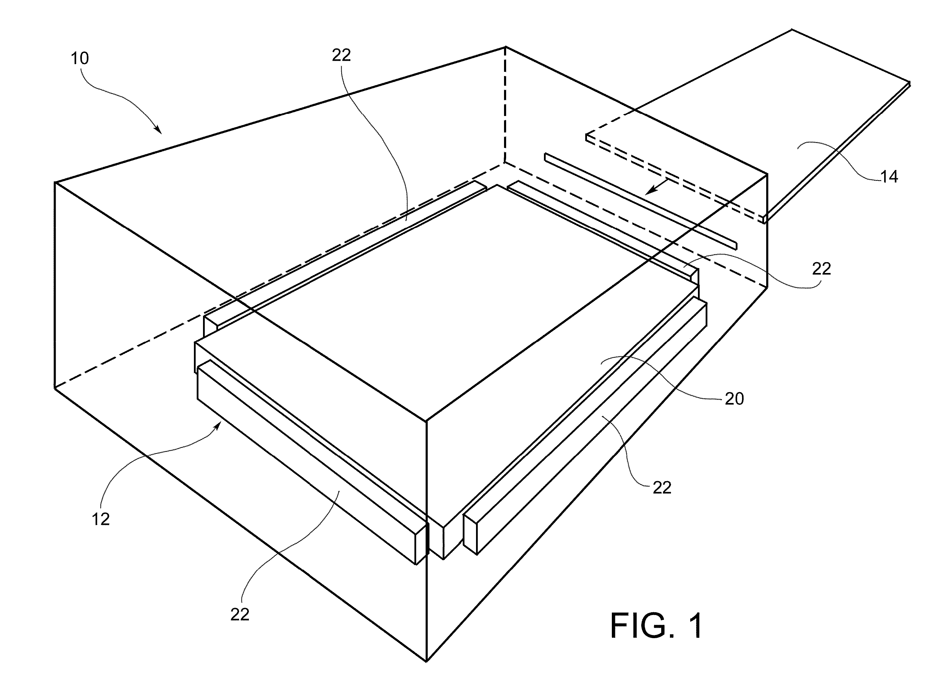

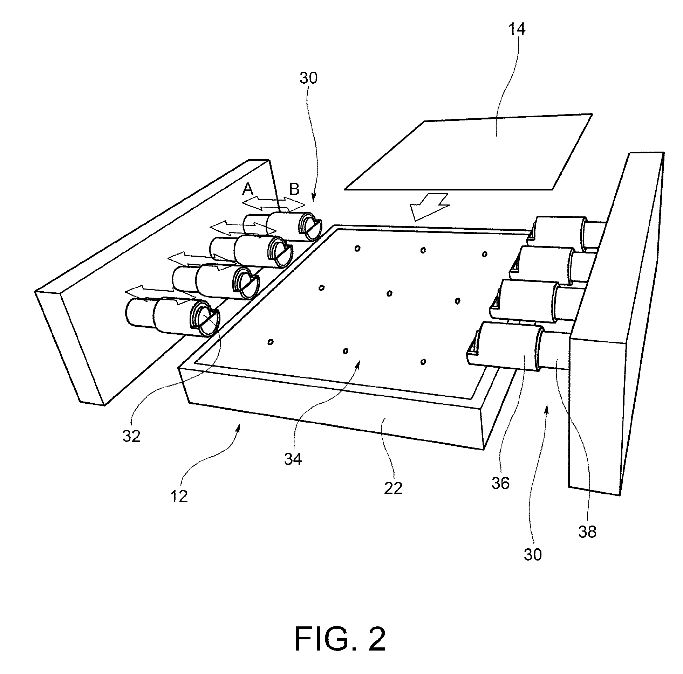

The prior art can be more easily understood by reference to the attached drawings, in which
Figure 1 is a schematic axonometric illustration of a reaction chamber for the deposition of a film on a substrate, and Figure 2 is a schematic cross-sectional view of a hot plate assembly of the reaction chamber, and an associated structure for moving the panels being processed.

Figure 1 is a schematic illustration of a reaction chamber 10 for the deposition of thin films on a substrate, for example a reaction chamber of a photovoltaic module production installation, according to the preferred application, to which reference will be made throughout the remainder of the description.

The reaction chamber 10 comprises a hot plate assembly 12 for receiving on its upper face, in contact with this face, a front glass panel 14 of a photovoltaic module, supplied by a conveying station of the installation (not shown) in the direction indicated by the arrow.

The hot plate assembly comprises a hot plate 20 and a side structure including a plurality of protective bars 22 arranged along the perimeter of the plate.

Figure 2 is an exemplary cross-sectional illustration of a hot plate assembly and an associated panel conveying system, in which the mechanical structure of the conveying system in relation to the hot plate and the corresponding protective side bars is shown more fully.

The system for conveying the substrate panel in the operating position includes:
- a plurality of supports 30 which are lateral with respect to the direction of advance, and can be moved between a more distant position A and a closer position B relative to the hot plate assembly, the supports being provided with rollers 32 for supporting and conveying the panel; and
- an arrangement of support pins 34 distributed regularly over the area of the hot plate and adapted to move the panel from a lowered position, in contact with the hot plate, to a raised position for the operation of the lateral supports (in which operation the panel is picked up by, or deposited on, these supports) for the movement of the panel into or out of the reaction chamber.

The lateral supports receive the panel entering the reaction chamber, in a horizontal position, and carry it to the hot plate. When the correct position has been reached, the panel support pins emerge from the hot plate assembly and rise to a height sufficient to detach the panel from the lateral conveying supports, which are freed and moved into a retracted position, after which the support pins are lowered to place the panel on the hot plate assembly.

The glass panel forming the deposition substrate is placed on, and in contact with, the hot plate, and is exposed to a flow of gaseous precursors of zinc oxide from above.

At the end of the deposition, the support pins are raised again, elevating the panel until the lateral conveying supports can be introduced under it, the panel then being gently supported on these supports while the support pins are lowered. The lateral supports are then actuated to convey the panel, by means of the advance rollers, to the exterior of the reaction chamber, where further conveyors transfer the panel to the next stations.

Unfortunately, the protective bars along the perimeter of the plate, which are required in order to protect the panel from back-coating phenomena and to protect the hot plate from unwanted deposits which would adversely affect its operation, also create a partial obstacle to the correct movement of the lateral conveying supports, whose travel towards the plate has to be limited so as not to interfere with the bars.

This problem is mitigated, but not wholly eliminated, by a better design of the profile of the protective bars.

The present applicant has devised improved protective bars in which the body of each bar has a general polygonal cross section, characterized by a chamfer on the angle of the upper face on the opposite side from the plate. This chamfer advantageously improves the operation of the panel transport and positioning mechanism, by enabling the movable supports for conveying the panel to move correctly in their approach to the hot plate, thus reducing the risk of interference with the bars, even if there are considerable unwanted depositions of film on the protective bars.

In the known supports, a movable hollow cup-shaped protective element 36 is fitted on a cylindrical support member 38 which is associated with actuating means for the reciprocating movement of the panel support roller towards and away from the hot plate assembly. The support roller is exposed at the end of its cup-shaped element facing the plate assembly, is protected by a shell in its lower semicircular portion, and is exposed in its upper semicircular portion where it comes into contact with the panel to be moved.

The support member, the cup-shaped protective element and the corresponding roller are typically made of steel.

The cup-shaped element is guided in its translational movement on the support member by the actuating means acting on the support roller, and is retained rotationally by the interference of a centring pin or dowel, which emerges from the inner surface of the cup, with a slide channel formed in the outer surface of the cylindrical support, on the upper mid-line of the cylinder.

This arrangement has the drawback that, when the cup-shaped elements are in their extended condition, i.e. when they are in the position nearest the plate assembly, they tend to become inclined downwards under their own weight and also under the weight of the panel supported by them, because they are only retained to a small degree by the support member. This leads to contact between the cup-shaped element and the protective bar, with a risk of jamming during the extension of the cup or friction when the cup is retracted.

The material from which all the components of the support are made gives rise to a further drawback. This is because, in photovoltaic module production applications in which a zinc oxide film is deposited to form the electrodes of the cells, the steel parts retain the zinc oxide and therefore the exposed surfaces of the components (the cup-shaped elements, the support member and the rollers) become contaminated to such an extent that the movement of the supports is adversely affected. Periodic cleaning of the parts is therefore required, making it necessary to stop the machine, while the process of removing the zinc oxide deposit from the affected parts is difficult and entails risks of damage to the parts, leading to a need for frequent replacement.

An annular brush, positioned on the outer circumference of the support member, is retained by a pair of stop rings, and interacts with the inner surface of the cup-shaped element in order to remove the zinc oxide deposit from it by friction. However, this system is not sufficient to clean all the parts subject to degradation.

The object of the present invention is to provide a satisfactory solution to the aforesaid problems, and more specifically to provide supports for a panel conveying system in a reaction chamber, advantageously a reaction chamber for the deposition of a zinc oxide film in a photovoltaic module production process, which overcome the difficulties of degradation and deformation.

A further object of the invention is to simplify the structure of the supports, and to facilitate their maintenance.

More generally, the object of the invention is to increase the output of a photovoltaic module manufacturing process.

According to the present invention, these objects are achieved by means of a support for conveying a panel in a reaction chamber for the deposition of a thin film having the characteristics claimed in Claim 1.

Specific embodiments are described in the dependent claims, the content of which is to be considered as an integral part of the present description.

The invention also proposes a system for conveying substrate panels for the production of photovoltaic modules and a reaction chamber of a photovoltaic module production installation, for the deposition of a thin film on a substrate, particularly for the deposition of a zinc oxide film on a glass panel of a photovoltaic module, as claimed.

In summary, the present invention proposes modifications to the structure and materials of the supports of a system for conveying a panel in a reaction chamber, including:
- coupling each of the cup-shaped protective elements to the corresponding support members by means of a pair of lateral supports which are positioned symmetrically about an axial vertical plane of the element, and which are preferably a pair of diametrically opposed supports lying on a horizontal mid-plane, these supports being adapted to prevent the forward inclination (or "pitching") of the cup-shaped element in the extended position;
- reducing the transverse dimensions of the ends of the cup-shaped elements facing the plate assembly, particularly by tapering them, in order to overcome the interference with protective bars which are raised above the upper surface of the hot plate and surmount the perimetric edge of the plate;
- making the cup-shaped elements from steel and making the support members and support rollers from Teflon or similar material which is impervious to the action of zinc oxide.

The improvements which are described can be made to the supports individually or as a whole. It will be evident to persons skilled in the art that each individual improvement to a specific component of the support can be made independently of the others, and can therefore be claimed independently and will not become less effective if the other illustrated improvements are not made.

Further characteristics and advantages of the invention will be disclosed more fully in the following detailed description of one embodiment of the invention, provided by way of non-limiting example, with reference to the attached drawings, in which:
Figure 3 is a perspective view of a lateral support for a panel conveying system according to the invention;
Figure 4 is an exploded perspective view of the lateral support for a panel conveying system shown in Figure 3;
Figure 5 is an exemplary partially sectional illustration of a hot plate assembly and an associated panel conveying system, in which the mechanical structure of the conveying system in relation to the hot plate and to improved protective side bars is shown more fully;
Figure 6a is a perspective view of a support member of a lateral support of the conveying system according to the invention;
Figures 6b and 6c are plan views of the support member of Figure 6a, and Figure 6d is a sectional view along the line A-A of Figure 6b;
Figure 7a is a perspective view of a cup-shaped protective element of a lateral support of the conveying system according to the invention;
Figures 7b and 7c are plan views of the cup-shaped element of Figure 7a, and Figure 7d is a sectional view along the line A-A of Figure 7b;
Figure 8 is a perspective view of a clamp for retaining lateral supports of the cup-shaped element according to the invention;
Figures 9a-9c are plan views of a supporting roller of a lateral support according to the invention;
Figures 10a and 10b are plan views of the supporting according to the invention shown in Figure 3, and Figure 10c is a sectional view along the line A-A of Figure 10b.

The following description refers to a photovoltaic module production installation, and in particular to a reaction chamber 10 adapted to receive a substrate panel 14 to be subjected to chemical vapour deposition, in controlled temperature and pressure conditions, of a thin film of transparent conductive oxide (TCO), typically zinc oxide, for the formation of an electrode layer of a plurality of solar cells.

The general structure of the reaction chamber and the configuration of the hot plate assembly and the associated system for moving the panels are similar to those shown in Figures 1 and 2.

The hot plate assembly 12 according to the invention comprises a hot plate 20 and a side structure including a plurality of protective bars 22 arranged along the perimeter of the plate.

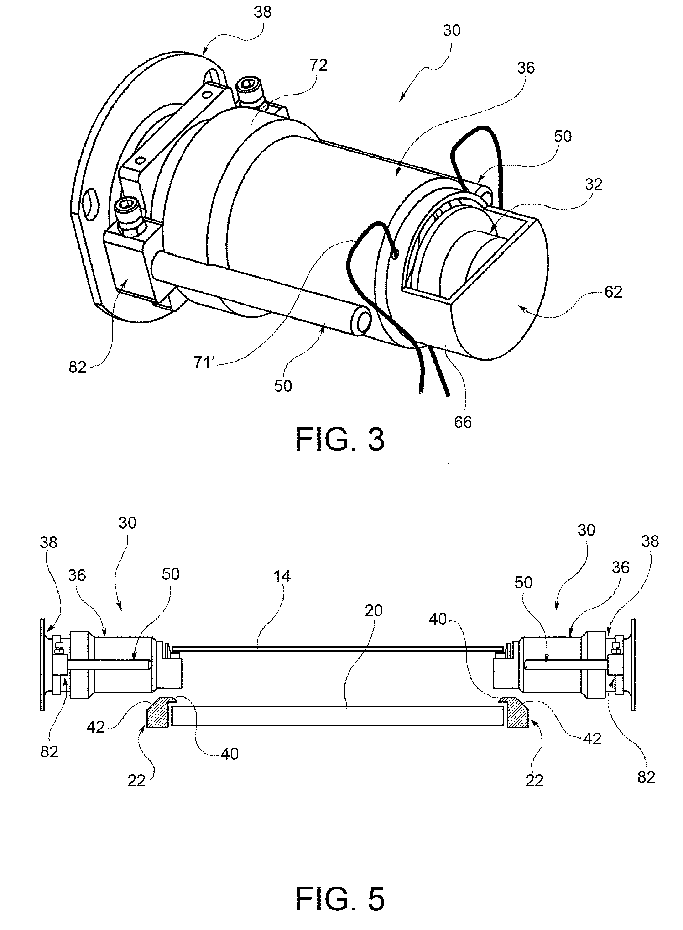

As shown in Figure 5, each protective bar 22 is provided with a projecting longitudinal formation 40 in the form of a fin or strip, projecting substantially along the whole length of the bar and adapted to surmount the corresponding edge of the surface of the hot plate 20 so as to protect the edges of the plate from any undesired deposition of zinc oxide caused by back coating.

The bars are made of heat-conducting material, preferably aluminium, but can equally well be made of any type of metal alloy or polymer resistant to high temperatures.

The body of each protective bar has an overall cross section of polygonal, preferably square, shape, and the root of the strip 40 is located at an upper angle of the bar, where the adjective "upper" relates to the position of the bar in association with the hot plate when in use.

Each lateral bar, or preferably at least each of the bars positioned laterally with respect to the direction of movement of the panels in the reaction chamber, has a chamfer 42 on the angle of the upper face opposite the angle at which the root of the projecting strip is located. This chamfer advantageously improves the efficiency of the panel transport and positioning mechanism. Essentially, the chamfered shape of the upper faces of the bars, which ensures that these faces are sufficiently distant from the movable element of the support if any unwanted deposition of zinc oxide occurs, also allows the movable panel conveying supports to move correctly at all times towards the hot plate, by reducing the risk of interference with the bars.

The panel conveying system is a system having a conventional general structure, installed on lateral walls of the reaction chamber, with a conventional number of seats for the lateral supports 30 located in conventional positions (in terms of height above the base of the chamber), and with known actuator devices for moving the supports towards and away from the hot plate assembly.

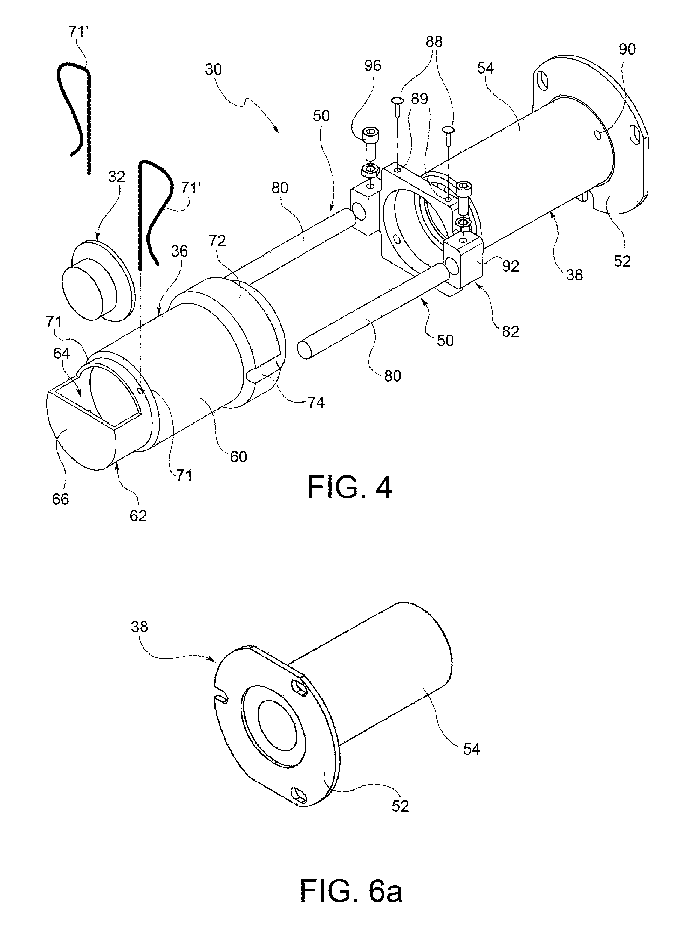

A support according to the invention is shown in Figures 3 and 4, in an overall view and in an exploded view showing the main components, respectively. Figure 5 shows, in a partially sectional view, the association of opposed supports with a hot plate equipped with the improved lateral protective bars described above.

Each support 30 has a support member 38 mounted rigidly on the corresponding wall by means of an end flange, on which a cup-shaped protective element 36 is fitted so as to be translatable, this element being supported and guided in its translational movement by a pair of lateral supporting elements 50 lying on a horizontal plane, a panel supporting roller 32 being exposed at the end of the lateral supporting elements facing the hot plate.

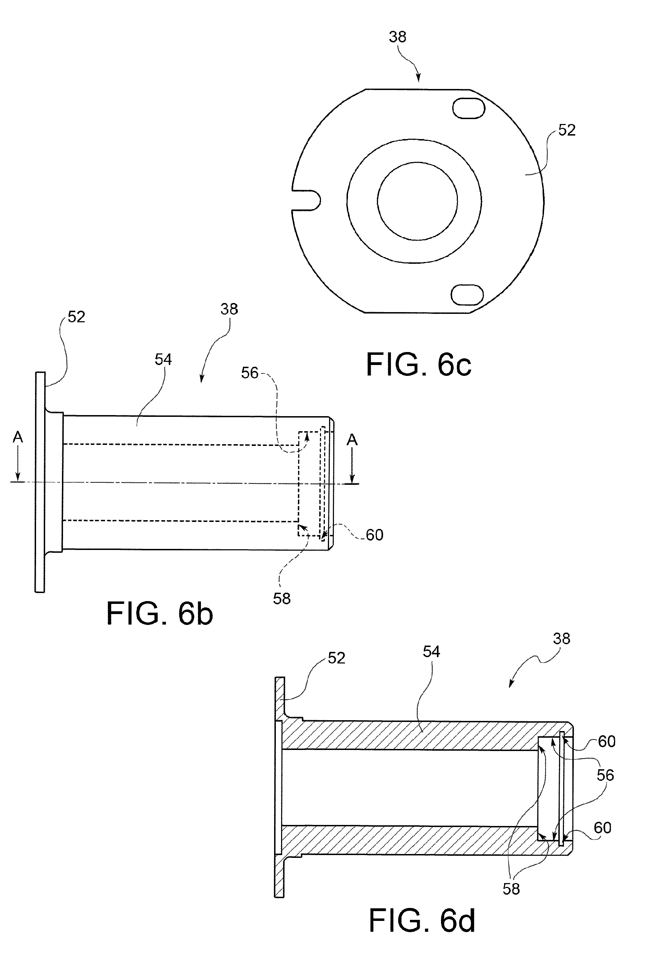

With reference to Figures 6a-6d, a currently preferred embodiment of the support member according to the invention will now be described. Figure 6a is a perspective view of the member, Figures 6b and 6c are plan views, from the side and the front respectively, and Figure 6d is a view in axial longitudinal section along the line A-A of Figure 6b.

The number 52 indicates a flange for fastening the member to the wall of the reaction chamber. The member has a hollow cylindrical body 54 to allow the travel of the shaft of a conventional actuator device (not shown) on the end of which the supporting roller is fitted.

At the distal end of the flange, the wall of the body 54 is tapered to form the seat 56 for housing an annular brush to remove the zinc oxide film deposited on the shaft of the actuator device. The seat 56 for the brush is delimited towards the flange by an annular bearing surface 58 and towards the outside by a locking ring (Seeger ring) housed in a corresponding circumferential seat 60 cut into the surface of the inner part of the cylindrical body 54.

The support member is conveniently made of Teflon, by internal machining, and is therefore lighter than a steel member.

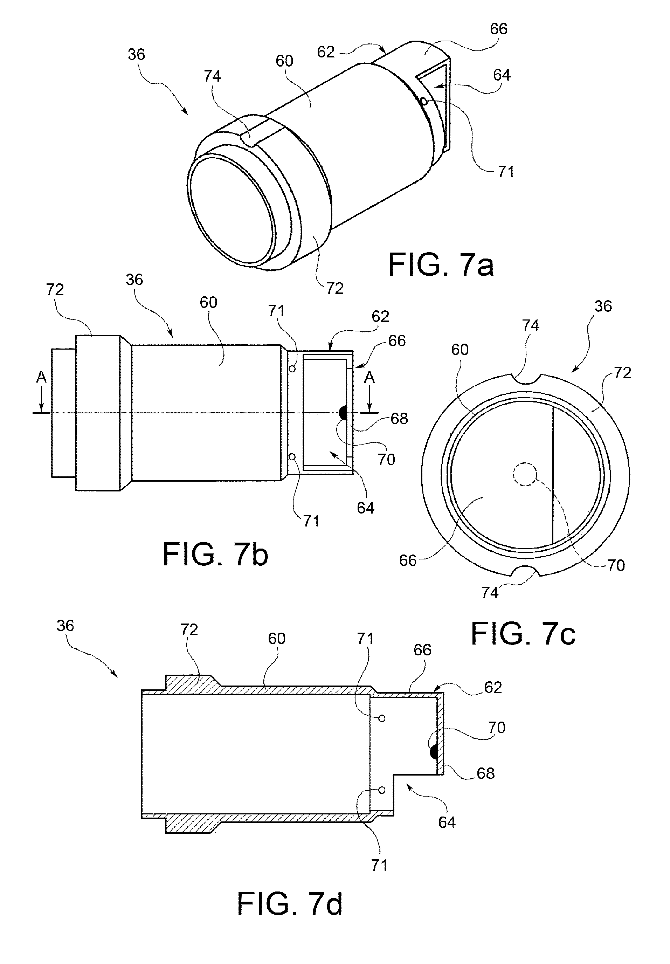

With reference to Figures 7a-7d, a currently preferred embodiment of the cup-shaped protective element according to the invention will now be described. Figure 7a is a perspective view in which the element is shown rotated through 90 degrees from its operating position; Figure 7b is a view from above; Figure 7c is a front view in which the element is shown rotated through 90 degrees from its operating position; and Figure 7d is a view in axial longitudinal section along the line A-A of Figure 7b.

As is known, the protective element 36 has a hollow cylindrical body 60 adapted to be fitted on the support member 38. The end section which is distal to the root of the support member, and which is indicated by 62 in the drawing, is designed to house a panel supporting roller 32, and has smaller transverse dimensions than the body 60, being made for example with a tapered configuration over a length in the longitudinal direction of extension of the element at least equal to the width of the protective bar, and at a height comparable with the maximum height of the strip of the protective bar which surmounts the edge of the hot plate.

Advantageously, this structural modification enables a pre-existing movement structure to be adapted to a hot plate assembly provided with improved protective bars as described above. As a result of this adaptation, the movement of the lateral supports towards and away from the plate is equally possible without interference with the protective bars, which have a greater vertical extension than that of known bars.

The distal end section 62 of the cylindrical body is open over a portion of its lateral surface defined by a cylindrical section of reduced height 64, with a centre angle in the range from 88° to 120° and preferably equal to 90°. The closed lateral surface portion forms a shell 66 for receiving the supporting roller 32. On the base wall 68 at the distal end, facing the inside of the element, there is an axial pin 70 or similar axial bearing projection, adapted to receive the supporting roller which bears on it in its extending movement, in other words the movement by which the roller approaches the hot plate assembly, thus causing the simultaneous extension of the cup-shaped element. Two pairs of through holes 71 facing a cross section of the element in pairs are formed on the lateral surface of the distal end section 62, in the closed portion of the cylindrical body, to allow the insertion of pins or clips 71' to bear against the supporting roller 32. In its opposite end section, in other words the section which is proximal to the root of the support member, the body 60 has a collar 72 projecting radially from the surface of the body, on which two parallel longitudinal grooves 74 are formed in diametrically opposite positions.

The cup-shaped protective element 36 is retained on the corresponding support member 38 and is guided in its axial translational movement by a pair of longitudinal supports 50 which are positioned symmetrically about an axial vertical plane of the element, and which are adapted to prevent the forward inclination (or "pitching") of the cup-shaped element in the extended position.

In the preferred embodiment, shown in Figures 3 to 5 and 10a to 10c, the lateral supports 50 comprise a pair of diametrically opposed bars 80 of circular cross section, lying on a horizontal mid-plane of the support, and engaging in the grooves 74. The bars 80 are held in position by a clamp 82 which is designed to grip one end of the bars, and which can be fitted and stably retained on the cylindrical body 54 of the support member 38.

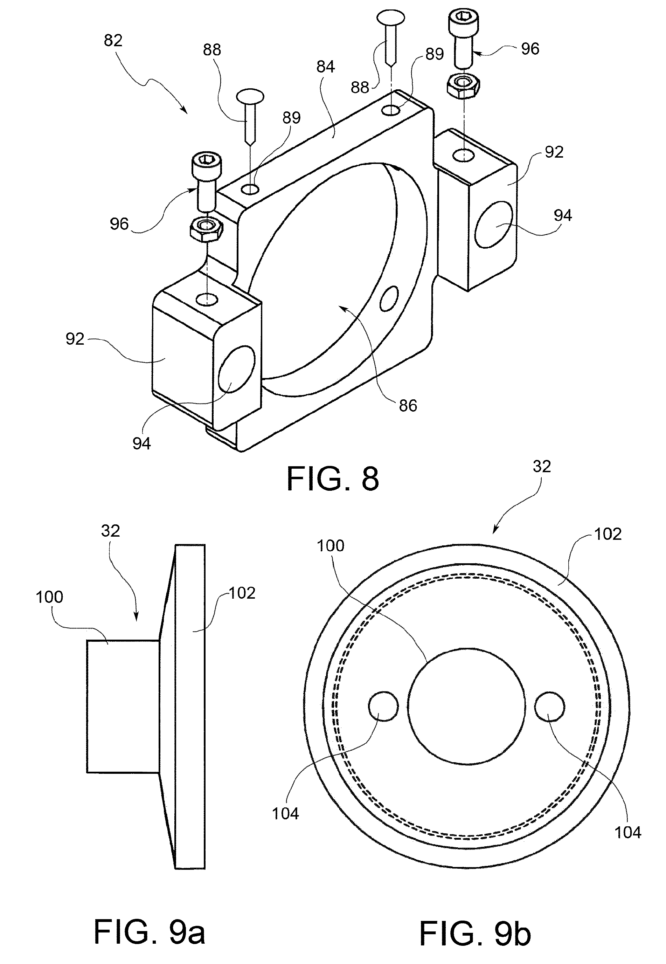

Figure 8 is a perspective view of a clamp 82 for retaining lateral supports of the cup-shaped element according to the invention. The clamp has an annular central body 84 whose aperture 86 has an inner circumference substantially matched to the circumference of the outer surface of the body of the support member, on which the clamp is retained by fastening screws 88 which engage in through holes 89 in the clamp and are screwed into seats 90 in the body of the support member 38. A pair of blocks 92 in diametrically opposed positions are provided on the sides of the central body 84, these blocks forming corresponding engagement seats 94 for the bars 80, which are locked in position by screws, bolts or similar fastening elements 96.

The clamp 82 and the bars 80 are preferably made of stainless steel or similar alloys.

In an alternative embodiment of the elements for reinforcing the cup-shaped protective element on the support member, a pair of diametrically opposed grooves or furrows is formed on a horizontal mid-plane of the cylindrical body of the support member, these grooves extending along the whole length of the cylindrical body or the greatest part thereof, corresponding to the permitted translational travel of the cup-shaped element.

On the inner lateral surface of the cylindrical body there are formed at least two centring pins or clips, positioned symmetrically about an axial vertical plane of the element, preferably in diametrically opposed positions, and lying on a horizontal mid-plane, these pins being adapted to engage in corresponding guide grooves or furrows formed on the wall of the cylindrical body of the support member.

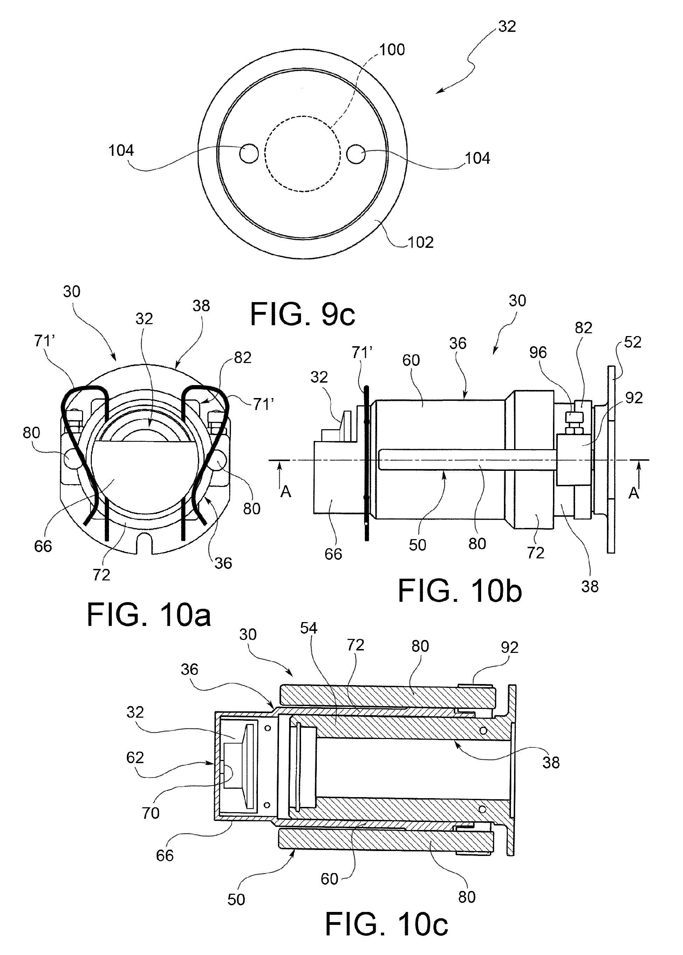

Figures 9a-9c show an embodiment of the panel supporting roller 32. The roller has a hollow cylindrical central body 100, for the passage of actuating means (not shown), and a truncated conical end flange 102. The number 104 indicates two diametrically opposed circular holes formed on the flat of the flange, adapted to house screws for coupling the roller to the actuating means.

The cup-shaped element 36 is guided in its translational movement on the support member 38 by the actuator means acting on the supporting roller, and is retained rotationally by the interference of the bars 82, which are fixed to the support member, with the grooves 74 formed on the collar of the cup-shaped element, or, in an alternative embodiment, by the interference of the centring pins or dowels emerging from the inner surface of the cup-shaped element with the corresponding guide channels or furrows formed on the outer surface of the body of the support member.

The cup-shaped element is driven in its translational movement towards the hot plate assembly by the force exerted by the supporting roller on the axial bearing pin of the base, in the course of the extending movement of the roller. In the retracting movement of the roller, in the direction away from the hot plate assembly, the cup-shaped element is driven by the traction exerted by the supporting roller on the pair of bearing pins or clips 71' inserted through the corresponding pairs of facing through holes 71 formed in the body of the cup-shaped element.

Advantageously, the coupling of the cup-shaped element to the support member by means of a pair of lateral supports, which are even more advantageously placed in a diametric position, provides greater axial stability of the assembly and prevents the cup-shaped element from being inclined forwards under its own weight, thus reducing the risk of contact and friction with the protective bars of the hot plate assembly.

Conveniently making the cup-shaped element of steel enables the element to slide more easily on the Teflon support, and allows the part to be manufactured on a lathe without costly forging. Furthermore, making the supporting rollers from Teflon facilitates their maintenance, because it is no longer necessary to remove any zinc oxide deposits.

In a variant embodiment, in which the supporting rollers are made of steel as in the prior art, it would be feasible to provide O-rings for contact with the panel, circumferentially with respect to the supporting roller. The use of O-rings to support the panel would avoid rubbing and heat conduction caused by the steel contact surface, which often result in damage to the glass of the panel due to thermal stress. For maintenance purposes it would simply be necessary to replace the O-rings, without any need to remove retaining elements such as steel screws in order to extract the whole component, these retaining elements being subject to degradation as a result of their exposure to the zinc oxide.

It should be noted that the embodiment of the present invention proposed in the preceding discussion is purely exemplary and does not limit the present invention. A person skilled in the art can apply the present invention in different embodiments which do not depart from the principles described above, and which are therefore included in the present patent.

As is well known, zinc oxide acts as a transparent conductive oxide for the formation of thin films for use as electrodes in solar cells, liquid crystal displays (LCDs), and flat display panels in general, and therefore the invention is applicable not only to the photovoltaic module industry but also, more generally, to electronic circuits using zinc oxide or other materials whose undesired deposition on a support for the material being processed leads to the degradation of the support, entailing costs of replacement or cleaning.

Naturally, the principle of the invention remaining the same, the forms of embodiment and details of construction may be varied widely with respect to those described and illustrated, which have been given purely by way of non-limiting example, without thereby departing from the scope of protection of the present invention as defined by the attached claims.

## Claims

1. Support (30) for conveying a substrate panel (14) in a reaction chamber (10) for the deposition of a thin film, comprising a roller (32) for moving the panel (14) relative to a hot plate assembly (12), the roller being translatable longitudinally between a first operating position at a distance from the hot plate assembly (12) and a second operating position close to the hot plate assembly (12), and being at least partially exposed from a coaxial protective element (36) which is axially slidable on a support member (38) fixed to a structure of the reaction chamber,
**characterized in that** the protective element (36) is coupled to the support member (38) by means of a pair of longitudinal supporting elements (50) positioned symmetrically about an axial vertical plane of the element.

2. Support (30) according to Claim 1, in which the longitudinal supporting elements (50) lie on a horizontal mid-plane of the support.

3. Support (30) according to Claim 1 or 2, in which the protective element (36) has reduced transverse dimensions at a distal end which faces the hot plate assembly (12) when in use.

4. Support (30) according to Claim 1, 2 or 3, in which the protective element (36) is made of steel, the support member (38) and the supporting roller (32) are made of Teflon or similar material which is impervious to the action of zinc oxide.

5. Support (30) according to any one of the preceding claims, in which the support member (38) has a hollow cylindrical body (54) adapted to allow the axial travel of translational actuation means for the support roller (32), and provided at a first end with a fastening flange (52) designed for the rigid mounting of the member (38) on a structure of the chamber.

6. Support (30) according to Claim 5, in which the body (54) of the support member (38) has a tapered wall at a second end, forming an annular seat (56) for housing means for cleaning the actuation means of the supporting roller (32) which are slidable inside the body (54).

7. Support (30) according to Claim 6, in which the annular seat (56) is delimited on one side by an annular bearing surface (58) and on the other side by a stop ring which can be housed in a circumferential seat (60) cut into the surface of the inner wall of the body (54).

8. Support (30) according to any one of the preceding claims, in which the protective element (36) is designed to be driven in its translational movement on the support member (38) by the supporting roller (32) in its movement towards and away from the hot plate assembly (12).

9. Support (30) according to Claim 8, in which the protective element (36) is cup-shaped, and has, at a distal end which faces the hot plate assembly (12) when in use, a base wall (68) having an axial bearing projection (70) which faces the inside of the element (36), and which is adapted to receive the supporting roller (32) which bears on it in its movement towards the hot plate assembly (12).

10. Support (30) according to Claim 9, in which the protective element (36) has, on the lateral surface at its distal end, two pairs of through holes (71) facing a cross section of the element in pairs, these holes being designed to allow the insertion of bearing elements (71') adapted to interfere with the supporting roller (32) in its movement away from the hot plate assembly (12).

11. Support (30) according to any one of the preceding claims, in which the protective element (36) has a radially projecting collar (72) in which two parallel longitudinal grooves (74) are formed.

12. Support (30) according to Claim 11, in which the longitudinal supporting elements (50) comprise a pair of diametrically opposed bars (80), lying on a horizontal mid-plane of the support, retained at one end by a clamp (82) adapted to be fitted stably on the body (54) of the support member (38), the longitudinal supporting elements being adapted to engage in the grooves (74) formed on the collar (72) of the protective element (36).

13. Support (30) according to Claim 11, in which the longitudinal supporting elements (50) comprise a pair of centring formations emerging from the inner surface of the protective element (36), lying on a horizontal mid-plane of the support, and designed to engage in corresponding guide furrows extending along the body of the support member (38).

14. System for conveying panels (14) for the production of photovoltaic modules, comprising a plurality of supports (30) according to any one of Claims 1 to 13.

15. Reaction chamber (10) of a photovoltaic module production installation, for the deposition of a thin film on a substrate panel (14), including a panel conveying system according to Claim 14.
